(19) Europäisches Patentamt / European Patent Office / Office européen des brevets

(11) **EP 3 470 456 A1**

(12) **EUROPÄISCHE PATENTANMELDUNG**

(43) Veröffentlichungstag:
**17.04.2019 Patentblatt 2019/16**

(21) Anmeldenummer: **18198847.8**

(22) Anmeldetag: **05.10.2018**

(51) Int Cl.:
*C08J 7/04* (2006.01)  *C08J 7/12* (2006.01)
*B29C 59/18* (2006.01)  *B29C 61/02* (2006.01)
*B81C 1/00* (2006.01)  *B08B 17/06* (2006.01)

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: **13.10.2017 DE 102017218363**

(71) Anmelder: **Leibniz-Institut für Polymerforschung Dresden e.V.**
**01069 Dresden (DE)**

(72) Erfinder:
• **GLATZ, Bernhard**
**01187 Dresden (DE)**
• **KNAPP, André**
**01454 Radeberg (DE)**
• **FERY, Andreas**
**01067 Dresden (DE)**

(74) Vertreter: **Rauschenbach, Marion**
**Rauschenbach Patentanwälte**
**Bienertstrasse 15**
**01187 Dresden (DE)**

(54) **OBERFLÄCHENSTRUKTURIERTE POLYMERKÖRPER UND VERFAHREN ZU IHRER HERSTELLUNG**

(57) Die Erfindung bezieht sich auf das Gebiet der Polymerchemie und betrifft oberflächenstrukturierte Polymerkörper, wie sie beispielsweise in Solarzellen oder als Anti-Fouling-Folien in der Medizintechnik angewandt werden können.

Aufgabe der vorliegenden Erfindung ist es, oberflächenstrukturierte Polymerkörper anzugeben, die eine hohe Genauigkeit der Strukturierung hinsichtlich der Abmessungen auf der Oberfläche der Polymerkörper aufweisen.

Die Aufgabe wird gelöst durch oberflächenstrukturierte Polymerkörper bei denen Polymerkörper mit Abmessungen mindestens $\geq 100$ cm$^2$ vorliegen, deren Oberflächen mindestens teilweise mit mindestens einer nano- bis mikrometerdicken Schicht bedeckt sind und die Schichten mit den Polymerkörpern physikalisch und/oder chemisch gekoppelt sind und die Oberfläche der Polymerkörper mit den Schichten mindestens teilweise verformt sind, wobei die Verformung innerhalb einer Verformungsart periodisch ist und die Anordnung mehrerer unterschiedlicher Verformungsarten auf einem Polymerkörper anisotrop oder isotrop ist, und wobei der E-Modul des Materials des Polymerkörpers geringer ist als der E-Modul der Schichtmaterialien.

EP 3 470 456 A1

**Beschreibung**

Die Erfindung bezieht sich auf das Gebiet der Polymerchemie und betrifft oberflächenstrukturierte Polymerkörper, wie sie beispielsweise in Solarzellen oder als Anti-Fouling-Folien in der Medizintechnik, zur Verhinderung der Anhaftung von Viren und/oder Bakterien oder zur Modifikation der tribologischen Eigenschaften wie z.B. die Reibungsminimierung in industriellen Fertigungsprozessen angewandt werden können, sowie ein Verfahren zu ihrer Herstellung.

Polymere werden zahlreich und in den verschiedensten Gebieten der Technik angewandt. Dabei ist es oft hilfreich, dass Körper aus diesen Polymeren oberflächenstrukturiert sind. Diese Strukturierung kann auf physikalischem und/oder chemischem Wege erfolgen.

Bekannt ist die kontrollierte und gezielte Bildung von Falten über mechanische Prozesse in der Nano- und Mikro-Ebene. Dies wurde 1998 das erste Mal durch Bowden et al publiziert (N. Bowden et al: 1998; Nature, 393 - 6681, 146-9).

Seitdem wurde vielfach über neue Möglichkeiten und Herstellungsweisen dieses Systems berichtet, dabei wurden fast immer die Vorteile der sogenannten Weichen Lithographie gegenüber klassischer, strahlungsgestützter Lithographie betont, zu denen die mechanische Faltenbildung gehört. In der weichen Lithographie (orig. engl. "Soft Lithography") werden Strukturierungen in der Größenordnung und Präzision lithographischer Prozesse erreicht, jedoch ätz- und strahlungsfrei. Dies geschieht fast immer über mechanische Zug- und Druckprozesse mit weichen Substratmaterialien, daher die Bezeichnung der weichen Lithographie (Y. Xia et al. 1998, Science, 37 - 5, 550 - 575). Die zwei wichtigsten Vorteile sind namentlich der zeitliche und monetäre Aufwand sowie die potentielle Aufskalierbarkeit von Faltenbildungssystemen. Der erstgenannte Punkt hält einer Überprüfung meist stand, letzterer konnte jedoch bisher nicht praktisch angewendet und gezeigt werden.

Der Nachteil der bekannten Lösungen zu Faltenbildungsprozessen besteht im Wesentlichen darin, dass Polymeroberflächen nur im unteren $cm^2$-Maßstab gefaltet werden können.

Weiter ist aus der DE 10 2012 010 635 A1 ein Verfahren zur 3D-Strukturierung und Formgebung von Oberflächen aus harten, spröden und optischen Materialien bekannt. Dazu wird mittels eines Ultrakurzpulslasers die Oberfläche der Materialien durch direkte Ablation realisiert und die geformte Oberfläche mittels eines Plasmastrahls geglättet.

Ebenfalls bekannt ist nach der WO2012/031201 A3 ein Verfahren zur Herstellung einer Anti-Fouling-Oberfläche mit mikro- oder nanostrukturierter Beschichtung. Dabei wird ein Substrat gedehnt, die Oberfläche des gedehnten Substrates beschichtet und nachfolgend die Dehnung aufgehoben, so dass die beschichtete Oberfläche gestaucht wird. Dabei kann das Substrat zur Modifizierung bestrahlt werden und die Beschichtung der Substratoberfläche erfolgt ausschließlich mittels initialisierter chemischer Gasphasenabscheidung (iCVD).

Mit den bekannten Verfahren zur Herstellung von oberflächenstrukturierten Polymerkörpern können diese nur mit erhöhtem Aufwand und nicht ausreichend hoher Genauigkeit der Strukturierung und insbesondere nur mit einer im Wesentlichen isotropen Anordnung der Strukturierung bereitgestellt werden.

Aufgabe der vorliegenden Erfindung ist es, oberflächenstrukturierte Polymerkörper anzugeben, die eine hohe Genauigkeit der Strukturierung hinsichtlich der

Abmessungen auf der Oberfläche der Polymerkörper aufweisen, und ein einfaches und kostengünstigeres Verfahren zu ihrer Herstellung anzugeben.

Die Aufgabe wird durch die in den Ansprüchen angegebene Erfindung gelöst. Vorteilhafte Ausgestaltungen sind Gegenstand der Unteransprüche.

Bei den erfindungsgemäßen oberflächenstrukturierten Polymerkörper liegen Polymerkörper mit Abmessungen von mindestens $\geq 100\ cm^2$ vor, deren Oberflächen mindestens teilweise mit mindestens einer nano- bis mikrometerdicken Schicht bedeckt sind und die Schichten mit den Polymerkörpern physikalisch und/oder chemisch gekoppelt sind und die Oberfläche der Polymerkörper mit den Schichten mindestens teilweise verformt sind, wobei die Verformung innerhalb einer Verformungsart periodisch ist und die Anordnung mehrerer unterschiedlicher Verformungsarten auf einem Polymerkörper anisotrop oder isotrop ist, und wobei der E-Modul des Materials des Polymerkörpers geringer ist als der E-Modul der Schichtmaterialien.

Vorteilhafterweise liegen Polymerkörper mit Abmessungen von $100\ cm^2$ bis $100\ m^2$ vor.

Ebenfalls vorteilhafterweise ist eine Schicht mit einer Schichtdicke zwischen 10 nm und 100 $\mu m$ vorhanden.

Weiterhin vorteilhafterweise sind die Oberflächen mit einem Schichtverbund aus zwei bis 10 Schichten übereinander beschichtet, wobei die Gesamtdicke aller Schichten nicht mehr als 100 $\mu m$ beträgt.

Und auch vorteilhafterweise ist die Oberfläche eines Polymerkörpers vollständig oder teilweise mit einer Schicht oder einem Schichtverbund aus unterschiedlichen Schichtmaterialien über- und/oder nebeneinander beschichtet.

Vorteilhaft ist es auch, wenn die physikalische Kopplung von Polymerkörpern und Schicht oder Schichtverbund über mechanische Verzahnung oder mittels Van-der-Waals-Kräften realisiert ist und die chemische Kopplung von Polymerkörpern und Schicht oder Schichtverbund über chemisch kovalente Bindungen.

Weiterhin vorteilhaft ist es, wenn die Verformung innerhalb einer Verformungsart auf einem Polymerkörper periodisch und anisotrop ist.

Ebenfalls vorteilhaft ist es, wenn die Verformung bei der Anordnung von mehreren Verformungsarten auf einem Polymerkörper innerhalb einer Anordnung periodisch und isotrop ausgerichtet ist, zwischen den verschiedenen Verformungsarten anisotrop zueinander ausgerichtet ist.

Und auch vorteilhaft ist es, wenn die Polymerkörper mehrere Verformungsarten aufweisen, die sich hinsichtlich Periodizität, Abmessungen und/oder Form der Verformungen unterscheiden.

Von Vorteil ist es auch, wenn die Materialien der Polymerkörper Elastomere, thermoplastische Elastomere, Thermoplaste und/oder Duromere sind oder diese mindestens an ihrer zu beschichtenden Oberfläche vorhanden sind oder enthalten.

Weiterhin von Vorteil ist es, wenn die Schicht oder der Schichtverbund aus metallischen, polymeren, polymerverbundartigen, keramischen oder glasartigen Materialien besteht.

Ebenfalls von Vorteil ist es, wenn der E-Modul des Materials des Polymerkörpers um mindestens 1 Größenordnung geringer ist als der E-Modul der Schichtmaterialien.

Bei dem erfindungsgemäßen Verfahren zur Herstellung von oberflächenstrukturierten Polymerkörpern werden Polymerkörper mit Abmessungen mindestens $\geq 100\ cm^2$ einer Dehnung in mindestens einer Richtung mindestens oberhalb der kritischen Faltenbildungsspannung und bis maximal unterhalb der Bruchspannung des Materials der Polymerkörper unterzogen, im Stadium der Dehnung die Oberflächen der Polymerkörper mit mindestens einer nano- bis mikrometerdicken Schicht oder Schichtverbund mittels eines atmosphärischen Plasmas oder mittels Drucken oder mittels Rakeln beschichtet, und nachfolgend mindestens bereichsweise die Dehnung der Polymerkörper aufgehoben, wobei Materialen der Polymerkörper eingesetzt werden, deren E-Modul geringer ist als der E-Modul der aufgebrachten Schichtmaterialien, und wobei der Herstellungsprozess kontinuierlich durchgeführt wird.

Vorteilhafterweise wird die kritische Faltenbildungsspannung des Materials der Polymerkörper ermittelt gemäß

$$\sigma_c = \frac{F_c}{h\,w} = \left[ \frac{9}{64} \left( \frac{E_s}{1-v_s^2} \right) \left( \frac{E_k}{1-v_k^2} \right)^2 \right]^{1/3}$$

Ebenfalls vorteilhafterweise wird die Schichtaufbringung mittels atmosphärischer Plasmen, wie mittels Plasma-Jet, mittels Corona-Entladung oder mittels dielektrischer Barriereentladung durchgeführt.

Auch vorteilhafterweise werden Precursormaterialien der Schichtmaterialien eingesetzt.

Weiterhin vorteilhafterweise wird die Schichtaufbringung mittels eines Plasma-Jets realisiert, dessen Plasma-Wirkungsquerschnitt strahlförmig, rotierend kreisförmig und/oder linear flächig ist.

Mit der erfindungsgemäßen Lösung können erstmals oberflächenstrukturierte Polymerkörper angegeben werden, die eine hohe Genauigkeit der Strukturierung hinsichtlich der Abmessungen auf der Oberfläche der Polymerkörper aufweisen, und ebenso ein einfaches und kostengünstigeres Verfahren zu ihrer Herstellung.

Erreicht wird dies durch oberflächenstrukturierte Polymerkörper, die beispielsweise Formkörper wie Spritzgussteile oder Folien sind, die in zwei Dimensionen mit Abmessungen von mindestens $\geq 100\ cm^2$ vorliegen. Dabei müssen die Materialien der eingesetzten Polymerkörper als minimale Dehnung mindestens die kritische Faltenbildungsspannung aufweisen. Nur derartige Polymermaterialien können erfindungsgemäß oberflächenstrukturiert werden und als erfindungsgemäße oberflächenstrukturierte Polymerkörper vorliegen.

Die Erfindung ist besonders vorteilhaft anwendbar für eine Oberflächenstrukturierung von Polymerkörpern mit großen Abmessungen in Länge und Breite gegenüber ihrer Dicke, die mindestens $\geq 100\ cm^2$ betragen sollen, vorteilhafterweise aber auch 100 $m^2$ oder auch mehr betragen können.

Derartige großflächige, gegenüber den Polymerkörpern des Standes der Technik aufskalierte, oberflächenstrukturierte Polymerkörper, die in einem kontinuierlichen Prozess hergestellt worden sind, sind bisher noch nicht bekannt. Die erfindungsgemäße Aufskalierung der Polymerkörper soll im Rahmen der vorliegenden Erfindung bedeuten, dass nach dem Stand der Technik bekannte oberflächenstrukturierte Polymerkörper, deren Oberflächenstrukturierung der Verformung der erfindungsgemäßen Lösung entspricht, durch die erfindungsgemäße Lösung in deutlich größeren Abmessungen in Länge und Breite vorliegen können und herstellbar sind.

Die erfindungsgemäße oberflächenstrukturierten Polymerkörper weisen mindestens teilweise auf ihrer Oberfläche mindestens eine nano- bis mikrometerdicke Schicht oder einen Schichtverbund auf. Die Schichtdicke der Schicht oder des Schichtverbundes beträgt vorteilhafterweise zwischen 10 nm und 100 $\mu$m.

Die Abmessungen der Schicht oder des Schichtverbundes in Länge und Breite kann den maximalen Abmessungen des Polymerkörpers in Länge und Breite entsprechen oder geringer sein, wodurch die Abmessungen der Schicht oder des Schichtverbundes in Länge und Breite auch geringer als 100 cm2 sein können.

Im Falle eines Schichtverbundes kann dieser vorteilhafterweise aus zwei Schichten, aber auch bis 10 oder 100 oder mehrere 100 Schichten übereinander bestehen, wobei die Gesamtdicke aller Schichten mindestens eine Größenordnung geringer ist, als die Dicke des Polymerkörpers.

Auch kann die Oberfläche der Polymerkörper vollständig oder teilweise mit einer Schicht oder einem Schichtverbund bedeckt sein, wobei auf einem Polymerkörper auch Schichten oder Schichtverbunde aus unterschiedlichen Schichtmaterialien über- und/oder nebeneinander angeordnet sein können.

Die erfindungsgemäß vorhandenen Schichten oder Schichtverbunde können neben der erfindungsgemäßen Oberflächenstrukturierung auch funktionelle Eigenschaften für den gesamten oberflächenstrukturierten Polymerkörper aufweisen, beispielsweise können sie wasser- und / oder ölabweisend sein, elektrisch leitfähig bzw. isolierend, optisch reflektierend, absorbierend oder transmittierend sein.

Die Schichten oder Schichtverbunde sind mit den Polymerkörpern physikalisch und/oder chemisch gekoppelt. Die Kopplung der Schichtmaterialien mit dem Polymerkörpermaterial kann beispielsweise mittels Ionenbindung, Van-der-Waals-Kräfte, chemisch kovalente Bindungen oder auch über mechanische Verzahnung realisiert sein.

Die Oberflächenstrukturierung der Polymerkörper erfolgt im Wesentlichen durch Verformung der oberflächennahen Bereiche der Polymerkörper und der aufgebrachten Schichten oder Schichtverbunde. Dabei ist die Oberfläche der Polymerkörper mit den Schichten mindestens teilweise verformt.

Die Verformung ist erfindungsgemäß innerhalb einer Verformungsart periodisch und vorteilhafterweise auch anisotrop, kann aber auch isotrop sein

Unter anisotroper Verformung soll im Rahmen dieser Erfindung verstanden werden, dass die Verformung mindestens hinsichtlich ihrer Abmessungen in mindestens einer Richtung im Wesentlichen identische Verformungen zeigt. Isotrope Verformungen im Sinne der vorliegenden Erfindung sind ungleiche und/oder nicht identische Verformungen mindestens hinsichtlich ihrer Abmessungen in mehrere oder alle Richtungen der Verformungen.

Es können auch mehrere unterschiedliche Verformungsarten auf einem Polymerkörper angeordnet sein, bei denen die Verformung isotrop oder anisotrop ist. Vorteilhafterweise ist die Verformung auch homogen innerhalb einer Verformungsart und ebenfalls vorteilhafterweise sinusoidal, bi-sinusoidal oder quadro-sinusoidal.

Die Periodizität kann vorteilhafterweise 100 nm - 10 $\mu$m beispielsweise einer faltenartigen Verformung sein.

Die Verformung bei mehreren Verformungsarten auf einem Polymerkörper ist innerhalb einer Verformungsart vorteilhafterweise auch periodisch und anisotrop, aber zwischen den mehreren Verformungsarten auf einem Polymerkörper sind die verschiedenen Verformungsarten auch anisotrop zueinander oder können auch isotrop zueinander ausgerichtet sein.

Dabei können sich die Verformungsarten hinsichtlich Periodizität, Abmessungen und/oder Form der Verformungen unterscheiden.

Vorteilhafterweise können als Materialien für die Polymerkörper Elastomere, thermoplastische Elastomere, Thermoplaste und/oder Duromere vorhanden sein, oder diese sind mindestens an ihrer zu beschichtenden Oberfläche vorhanden.

Die Schichten oder Schichtverbunde können aus verschiedenen Polymermaterialien oder metallischen oder keramischen, anorganischen oder organischen Schichtmaterialien sowie aus Monolagen von Molekülen, Partikeln oder Kolloiden dieser Materialien vorhanden sein.

Die Auswahl der Materialien für die Polymerkörper und Schichten, die zusammen den erfindungsgemäßen oberflächenstrukturierten Polymerkörper bilden, erfolgt mindestens über den E-Modul der jeweiligen Materialien, der für alle einsetzbaren Materialien bekannt ist oder mit geringem Aufwand ermittelbar ist.

Dabei muss der E-Modul des Materials des Polymerkörpers um mindestens 1 Größenordnung geringer sein als der E-Modul der Schichtmaterialien.

Bei dem erfindungsgemäßen Verfahren zur Herstellung von oberflächenstrukturierten Polymerkörpern werden Polymerkörper mit Abmessungen in zwei Dimensionen von mindestens $\geq$ 100 cm$^2$ einer Dehnung in mindestens einer Richtung mindestens oberhalb der kritischen Faltenbildungsspannung und bis maximal unterhalb der Bruchspannung des Materials der Polymerkörper unterzogen.

Als minimale Dehnung der Polymerkörper muss mindestens die kritische Faltenbildungsspannung des Polymerkörpermaterials erreicht werden, die gemäß

$$\sigma_c = \frac{F_c}{h\,w} = \left[\frac{9}{64}\left(\frac{E_s}{1-\nu_s{}^2}\right)\left(\frac{E_k}{1-\nu_k{}^2}\right)^2\right]^{1/3}$$

ermittelt werden kann. Hierbei stehen $\varepsilon_c$ für die kritische Faltenbildungsspannung, $F_c$ für die entsprechende, kritische Kraft, h und w für Höhe und Breite des zu dehnenden Polymerkörpers, $E_s$ und $E_k$ für die jeweiligen Elastizitätsmoduln der Materialien von Polymerkörper und Schicht oder Schichtverbund, und $\nu_s$ und $\nu_f$ für deren zugehörige Querkontraktionszahlen.

Die Dehnung kann dabei in mindestens einer Richtung, aber auch gleichzeitig in mehreren Richtungen realisiert werden. Dadurch können auf einem Polymerkörper beispielsweise mehrere unterschiedliche Verformungsarten gleichzeitig hergestellt werden. Über Dehnung des Polymerkörpers in nur eine Raumrichtung (uniaxiale Dehnung) sind Verformungen in Form von parallelen Falten in zwei zueinander orthogonal stehenden Raumrichtungen (biaxiale Dehnung), sogenannte Herringbone- oder Chevron-Muster, herstellbar, die mit Fischgrätenmustern vergleichbar sind. Darüber hinaus sind auch Dehnungen des Polymerkörpers in zwei oder mehr zueinander nicht orthogonalen Richtungen möglich.

Dehnungen in uni- als auch bi-axialer Richtung führen auch zu komplexeren Verformungen, die aus sinusoidalen Falten bestehen können, sogenannten bi-sinusoidale und quadro-sinusoidale Falten.

Ein wesentlicher Vorteil der erfindungsgemäßen Lösung besteht darin, dass derartige Verformungen erfindungsgemäß in einem kontinuierlichen Prozess realisiert werden.

Nach Erreichen der Dehnung der Polymerkörper werden deren Oberflächen im Stadium der Dehnung mit mindestens einer nano- bis mikrometerdicken Schicht oder einem Schichtverbund beschichtet.

Die Beschichtung der Polymerkörper erfolgt dabei mittels eines atmosphärischen Plasmas, Drucken oder Rakeln.

Vorteilhafterweise erfolgt die Beschichtung mittels atmosphärischer Plasmen, wie mittels Plasma-Jet, mittels Corona-Entladung oder mittels dielektrischer Barriereentladung.

Dabei können die Schichtmaterialien oder Precursoren der Schichtmaterialien als Ausgangsstoffe für den Beschichtungsprozess eingesetzt werden. Als Precursoren werden besonders glasbildende Precursoren für die Aufbringung mittels eines atmosphärischen Plasmas eingesetzt. Dabei werden die Precursoren während der Plasmabeschichtung im Plasma fragmentiert (ionisiert, radikalisiert und mindestens vorpolymerisiert) und durch Rekombination die Schicht auf der Oberfläche erzeugt.

Als Materialien für die Polymerkörper können beispielsweise Polydimethylsiloxan (PDMS), Ethylen-Proplyen-Dien-Kautschuk (EPDM) oder Hydrierter Acrylnitrilbutadien-Kautschuk (HNBR) und als Precursoren für die Beschichtung können beispielsweise Hexamethyldisiloxan (HMDSO), Hexamethyldisilazan (HMDSN), Tetramethyldisiloxan (TMDSO), Hexamethyltrisiloxan (HMTSO), Tetramethylorthosilicat (TMOS) oder Tetraethylorthosilikat (TEOS) eingesetzt werden. Die E-Moduln von PDMS, EPDM oder HNBR sind jeweils geringer als die E-Moduln von HMDSO, HMDSN, TMDSO, HMTSO, TMOS oder TEOS.

Ebenso können Schichten und Schichtverbünde direkt im Material des Polymerkörpers gebildet, d.h. *in-situ* erzeugt werden. Hierzu werden polymere Materialien wie Silikone benötigt, die sich chemisch durch ihre glasbildende Eigenschaft auszeichnen, beispielsweise PDMS. Durch Oxidation, Radikalbildung, Ionisation oder Reduktion durchläuft das Material eine Metamorphose von einem polymeren hin zu einem glasartigen Werkstoff. Findet diese Umwandlung nur oberflächennah statt, wird hierdurch eine Schicht, ein schichtartiger Film oder ein Schichtverbund erzeugt.

Bisher sind der Einsatz von atmosphärischen Plasmen oder Drucken oder Rakeln zum Beschichten von Polymerkörpern und nachfolgende Verformung mindestens des Oberflächenbereiches und der aufgebrachten Schicht oder Schichtverbunde aus dem Stand der Technik nicht bekannt.

Als Schichtmaterialien können Materialen eingesetzt werden, die unter atmosphärischen Bedingungen in ein Plasma einspeissbar und verarbeitbar sind. Die können beispielsweise metallische, polymere, polymerverbundartige, keramische oder glasartige Materialien sein.

Die Schichtaufbringung kann dabei erfolgen, indem die gedehnten Polymerkörper unter den Werkzeugen für die Schichtaufbringung hindurchgeführt oder die Werkzeuge für die Schichtaufbringung über die gedehnten Polymerkörper hinweg geführt werden.

Vorteilhafterweise werden die gedehnten Polymerkörper unter den Werkzeugen für die Schichtaufbringung hindurchgeführt, wodurch sehr uniforme Wirkungsquerschnitte und eine hohe Homogenität der Strukturierung erreicht wird.

Praktischerweise werden für die Schichtaufbringung die sogenannten Roll-to-roll-Prozesse bei Einsatz von atmosphärischen Plasmen angewandt, die Streckvorrichtungen für die Polymerkörper aufweisen, die die Polymerkörper dehnen, also unter Spannung halten und bei denen während der gleichbleibenden Dehnung die Polymerkörper auf- oder abgerollt werden.

Für die erfindungsgemäße Oberflächenmodifizierung von Polymerkörpern werden Polymerkörper eingesetzt, bei denen der E-Modul des Polymerkörpermaterials geringer, vorteilhafterweise um mindestens 1 Größenordnung geringer, ist als der E-Modul der aufgebrachten Schichtmaterialien.

Nach der Aufbringung der Beschichtung auf die Polymerkörper wird mindestens bereichsweise die Dehnung der Polymerkörper aufgehoben, das heißt beispielsweise die mechanische und/oder thermische Spannung oder Spannung aufgrund von Quellungsvorgängen der Polymerkörper wird gelöst.

Von besonderer Bedeutung für die erfindungsgemäße Lösung ist es, dass der Herstellungsprozess kontinuierlich durchgeführt wird.

So können erfindungsgemäß großflächige bis sehr großflächige oberflächenmodifizierte Polymerkörper fortlaufend in einem kontinuierlichen Produktionsprozess hergestellt werden, was nach dem Stand der Technik bisher nicht erreicht wurde.

Mit dem erfindungsgemäßen Verfahren können erfindungsgemäße oberflächenstrukturierte Polymerkörper hergestellt werden, die eine hohe Genauigkeit der Strukturierung hinsichtlich der Abmessungen auf der Oberfläche der Polymerkörper zeigen. Dabei können einerseits gleichzeitig große Flächen bis in den Quadratmetermaßstab der Polymerkörper oberflächenstrukturiert werden und dabei eine hinsichtlich ihrer Abmessungen und Formen der Verformung homogene Strukturierung im nm-Bereich bis in den $\mu$m-Bereich erreicht werden.

Von weiterem Vorteil ist, dass nicht nur anisotrope Strukturierungen herstellbar sind, sondern gleichzeitig auf einem Polymerkörper auch isotrope Strukturierungen.

Ebenfalls ist es ein Vorteil der erfindungsgemäßen Lösung, dass die aufgebrachte Schicht oder der Schichtverbund funktionale Eigenschaften aufweist, wie beispielsweise erhöhte oder verminderte Hydrophilizität, elektrische Leitfähigkeit oder elektrische Isolation, erhöhte oder verminderte optische Aktivität, wie Reflektion, Absorption oder Transmission, erhöhte chemische und mechanische Beständigkeit, sowie eine erhöhte oder verminderte Haft- sowie Gleitreibung, oder aber die Eigenschaften der aufgebrachten Schichten oder Schichtverbunde sind über die Parameter der Schichtaufbringung vorteilhaft beeinflusst worden.

Im Gegensatz zu Lösungen des Standes der Technik können mit der erfindungsgemäßen Lösung gezielt anisotrope, aber auch isotrope Strukturierung der Oberfläche von Polymerkörpern erreicht werden.

Ebenfalls können erfindungsgemäß beim Einsatz von plasma-gestützten Verfahren zur Beschichtung Monomere der Precursoren radikalisiert, auf die Oberfläche aufgebracht und polymerisiert werden. Bei Einsatz von plasma-assistierten Verfahren können Moleküle zum Einsatz kommen, die nicht ausschließlich radikalisch oder ionisch polymerisiert werden können. Hier spielen weitere physikalische und chemische Vorgänge eine Rolle, die auch über Fragmentation und Rekombination von Molekülen erfolgen und so andere Vernetzungen als nur Polymerisationsvorgänge erlauben.

Nachfolgend wird die Erfindung an mehreren Ausführungsbeispielen näher erläutert.

Beispiel 1

Eine 100 x 20 x 0,025 cm Folie aus Polydimethylsiloxan (PDMS) mit einem E-Modul von 2.5 MPa wurde in eine Roll-to-Roll-Streckapparatur eingespannt. Die Dehnung der Folie war dabei auf einen konstanten Wert von 10 % eingestellt. Für die Beschichtung der effektiv zur Verfügung stehenden Fläche der Polymerfolie von 70 x 20 cm wurde diese mit einer punktförmigen Plasma-Düse (PlasmaTreat GmbH, Steinhagen, Deutschland) von 1 cm Durchmesser überfahren. Der Düsenabstand zur Probenoberfläche betrug 10 mm, die Nennleistung der Plasma-Düse lag bei 5,04 kW (280 V bei 18 A), die Fahrgeschwindigkeit der Düse über der Probe betrug 100 mm/s.

Als Precursoren für die Schichtabscheidung wurde Tetraethylorthosilicat (TEOS), mit einem E-Modul der resultierenden Schicht von 450 MPa der Plasma-Düse zugeführt. Mittels der Plasma-Düse wurde eine gleichmäßig 100 nm dicke Schicht abgeschieden, die nach der Abscheidung aus oligomerem, wenig vernetztem Silikat bestand.

Mit dem Abrollen der beschichteten Polymerfolie von der letzten Rolle der Roll-to-Roll-Streckapparatur wurde die Dehnung während des kontinuierlichen Prozesses beendet und es lag eine oberflächenstrukturierte Polymerfolie vor.

Die Oberflächenstrukturierung bestand aus anisotrop angeordneten Falten mit einer Periodizität von 1,5 μm und einer Strukturhöhe von 450 nm.

Beispiel 2

Eine 100 x 20 x 0,1 cm Folie aus Acrylnitril-Butadien-Kautschuk (NBR) mit einem E-Modul von 2,3 MPa wurde in eine Roll-to-Roll-Streckapparatur eingespannt.

Die Dehnung der Folie war dabei auf einen konstanten Wert von 8 % eingestellt. Die für die Beschichtung der effektiv zur Verfügung stehenden Fläche der Polymerfolie von 70 x 20 cm wurde diese mit einer rotierenden Plasma-Düse (PlasmaTreat GmbH, Steinhagen, Deutschland) von 0,5 cm Durchmesser überfahren. Der Düsenabstand zur Probenoberfläche betrug 16 mm, die Nennleistung der Plasma-Düse lag bei 4,77 kW (265 V bei 18 A), die Fahrgeschwindigkeit der Düse über der Probe betrug 100 mm/s.

Als Precursor für die Schichtabscheidung wurde Hexamethyldisiloxan (HMDSO) mit einem E-Modul von 250 MPa der resultierenden Schicht der Plasma-Düse zugeführt. Die Abscheidungsrate des Precursors wurde zwischen 4 und 120 g/h variiert.

Mittels der Plasma-Düse wurde eine variierend dicke Schicht zwischen 5 und 200 nm abgeschieden, die nach der Abscheidung aus oligomerem, wenig vernetztem Silikat bestand.

Mit dem Abrollen der beschichteten Polymerfolie von der letzten Rolle der Roll-to-Roll-Streckapparatur wurde die Dehnung während des kontinuierlichen Prozesses beendet und es lag eine oberflächenstrukturierte Polymerfolie vor.

Die Oberflächenstrukturierung bestand aus anisotrop angeordneten Falten mit einer Periodizität zwischen 350 nm und 3,75 μm und einer Strukturhöhe von 100 nm und 1,15 μm nm.

Beispiel 3

Eine 100 x 50 x 0,0025 cm Folie aus Polydimethylsiloxan (PDMS) mit einem E-Modul von 2,5 MPa wurde auf ein Trägerpapier mit einer longitudinalen Vordehnung von 15 % ausgesetzt. Die für die Beschichtung der effektiv zur Verfügung stehende Fläche der Polymerfolie von 95 x 50 cm wurde einer Plasmabehandlung mit einer dielektrischen Barriereentladung (DBD) unterzogen (4-teilige DBE - Fraunhofer IST, Braunschweig, Deutschland).

Der Elektrodenabstand zur Probenoberfläche wurde auf 0,2 mm eingestellt, die Nennleistung der DBE lag bei 600 W, die Ab- bzw. Aufrollgeschwindigkeit bei 0,5 m/min.

Als Precursor für die Schichtabscheidung wurde Tetramethyldisiloxan (TMDSO) mit einem E-Modul von 300 MPa der resultierenden Schicht eingesetzt. Die Abscheiderate des Precursors wurde mittels Gastransport auf 7l/min eingestellt, was einer theoretischen Abscheiderate von ~3 g/h entspricht.

Nach dem Abrollen der beschichteten Polymerfolie von der letzten Rolle der Roll-to-Roll-DBE-Apparatur wurde die Dehnung beendet und es lag eine oberflächenstrukturierte Polymerfolie vor.

Die Oberflächenstrukturierung bestand aus anisotrop angeordneten Falten mit einer Periodizität zwischen 2,5 μm und 7 μm und einer Strukturhöhe zwischen 450 nm und 2 μm.

Beispiel 4

Eine 20 x 10 x 0,0075 cm Folie aus Polydimethylsiloxan (PDMS) mit einem E-Modul von 2,4 MPa wurde auf ein Trägerpapier mit einer longitudinalen Vordehnung von 20 % ausgesetzt. Ein UV-vernetzbares Harz wurde per 3D-Druck-Verfahren auf das PDMS aufgedruckt und bei 80 °C für 30 min gehärtet. Die erhaltene Schicht hatte ein E-Modul von 1,2 GPa bei einer Dicke von 20 $\mu$m. Nach dem Druck wurde die Probe entspannt. Die Oberflächenstrukturierung bestand aus anisotrop angeordneten Falten mit einer Periodizität von 475 $\mu$m und einer Strukturhöhe von 120 $\mu$m.

Beim Aufdrucken einer zweiten Schicht desselben E-Moduls wurde eine Gesamtschichtdicke von 40 $\mu$m erreicht, was zu einer Periodizität von 850 $\mu$ sowie einer Strukturhöhe von 200 $\mu$m führte. Eine dritte Schicht ergab 60 $\mu$m Gesamtschichtdicke sowie 1,15 mm Periodizität bei 300 $\mu$m Strukturhöhe.

Beispiel 5

Eine 40 x 10 x 0,2 cm Folie aus Ethylen-Propylen-Dien-Kautschuk (EPDM) mit einem E-Modul von 5,7 MPa wurde in eine Streckapparatur eingespannt. Die Dehnung der Folie war dabei auf einen konstanten Wert von 15 % eingestellt. Ein UV-vernetzbares Harz wurde per Rakel-Verfahren auf das EPDM aufgebracht und unter UV-Licht gehärtet. Die erhaltene Schicht hatte ein E-Modul von 500 MPa bei einer Dicke von 50 $\mu$m. Nach dem Härten wurde die Probe entspannt.

Die Oberflächenstrukturierung bestand aus anisotrop angeordneten Falten mit einer Periodizität von 200 $\mu$m und einer Strukturhöhe von 20 $\mu$m

Beispiel 6

1) Bi-sinusoidale und quadrosinsuoidale Faltenbildung

Eine 100 x 10 x 0,050 cm Folie aus Polydimethylsiloxan (PDMS) mit einem E-Modul von 2.1 MPa wurde in eine Roll-to-Roll-Streckapparatur eingespannt. Die Dehnung der Folie war dabei auf einen konstanten Wert von 85 % eingestellt. Für die Beschichtung der Polymerfolie wurde diese mit einer punktförmigen Plasma-Düse (PlasmaTreat GmbH, Steinhagen, Deutschland) von 1 cm Durchmesser überfahren. Der Düsenabstand zur Probenoberfläche betrug 10 mm, die Nennleistung der Plasma-Düse lag bei 6,3 kW (350 V bei 18 A), die Fahrgeschwindigkeit der Düse über der Probe betrug 25 mm/s.

Das PDMS wurde *in-situ* oxidiert umso die Schicht zu erzeugen. Die erhaltene Schicht hatte eine Dicke von 180 nm bei einem durchschnittlichen E-Modul von 150 MPa der resultierenden Schicht.

Mit dem Abrollen der beschichteten Polymerfolie von der letzten Rolle der Roll-to-Roll-Streckapparatur wurde die Dehnung während des kontinuierlichen Prozesses beendet und es lag eine oberflächenstrukturierte Polymerfolie vor.

Die Oberflächenstrukturierung bestand aus anisotrop angeordneten, bi-sinusoidalen Falten mit einer Periodizität von 1,5 $\mu$m und einer Strukturhöhe der tiefen Amplitude von 650 nm sowie der flachen Amplitude von 125 nm.

Bei Dehnung der Folie auf 95 % erhält man anisotrop angeordnete, quadro-sinusoidale Falten mit einer Periodizität von 1,45 $\mu$m und einer Strukturhöhe der tiefen Amplitude von 750 nm, der mittleren von 450 nm sowie der flachen Amplitude von 75 nm.

2) Zueinander orthogonales, bi-axiales Dehnen

Eine 100 x 10 x 0,125 cm Folie aus Polydimethylsiloxan (PDMS) mit einem E-Modul von 2.0 MPa wurde längs in eine Roll-to-Roll-Streckapparatur und quer dazu seitlich in zwei gleitende Folienstrecker aus Polytetrafluorethylen (PTFE) eingespannt. Die Dehnung der Folie war dabei in beiden zueinander orthogonalen Richtungen auf einen konstanten Wert von 5 % eingestellt. Für die Beschichtung der Polymerfolie wurde diese mit einer kreisförmig rotierenden Plasma-Düse (PlasmaTreat GmbH, Steinhagen, Deutschland) von 2,5 cm Durchmesser überfahren. Der Düsenabstand zur Probenoberfläche betrug 13 mm, die Nennleistung der Plasma-Düse lag bei 6,3 kW (350 V bei 18 A), die Fahrgeschwindigkeit der Düse über der Probe betrug 50 mm/s.

Das PDMS wurde *in-situ* oxidiert umso die Schicht zu erzeugen. Die erhaltene Schicht hatte eine Dicke von 110 nm bei einem durchschnittlichen E-Modul von 85 MPa der resultierenden Schicht.

Mit dem Abrollen der beschichteten Polymerfolie von der letzten Rolle der Roll-to-Roll-Streckapparatur wurde die Dehnung während des kontinuierlichen Prozesses beendet und es lag eine oberflächenstrukturierte Polymerfolie vor.

Die Oberflächenstrukturierung bestand aus anisotrop angeordneten Falten, die in regelmäßigen Mustern orthogonal zueinander gerichtet sind, auch Chevron- oder Herringbone-Struktur genannt. In beide Raumrichtungen lag eine Periodizität von 1,4 $\mu$m und einer Strukturhöhe von 80 nm vor.

**Patentansprüche**

1. Oberflächenstrukturierte Polymerkörper bei denen Polymerkörper mit Abmessungen mindestens $\geq$ 100 cm$^2$ vorliegen, deren Oberflächen mindestens teilweise mit mindestens einer nano- bis mikrometerdicken Schicht bedeckt sind und die Schichten mit den Polymerkörpern physikalisch und/oder chemisch gekoppelt sind und die Oberfläche der Polymerkörper mit den Schichten mindestens teilweise verformt sind, wobei die Verformung innerhalb einer Verformungsart periodisch ist und die Anordnung mehrerer unterschiedlicher Verformungsarten auf einem Polymerkörper anisotrop oder isotrop ist, und wobei der E-Modul des Materials des Polymerkörpers geringer ist als der E-Modul der Schichtmaterialien.

2. Oberflächenstrukturierte Polymerkörper nach Anspruch 1, bei denen Polymerkörper mit Abmessungen von 100 cm$^2$ bis 100 m$^2$ vorliegen.

3. Oberflächenstrukturierte Polymerkörper nach Anspruch 1, bei denen eine Schicht mit einer Schichtdicke zwischen 10 nm und 100 $\mu$m vorhanden ist.

4. Oberflächenstrukturierte Polymerkörper nach Anspruch 1, bei denen die Oberflächen mit einem Schichtverbund aus zwei bis 10 Schichten übereinander beschichtet sind, wobei die Gesamtdicke aller Schichten nicht mehr als 100 $\mu$m beträgt.

5. Oberflächenstrukturierte Polymerkörper nach Anspruch 1, bei denen die Oberfläche eines Polymerkörpers vollständig oder teilweise mit einer Schicht oder einem Schichtverbund aus unterschiedlichen Schichtmaterialien über- und/oder nebeneinander beschichtet ist.

6. Oberflächenstrukturierte Polymerkörper nach Anspruch 1, bei denen die physikalische Kopplung von Polymerkörpern und Schicht oder Schichtverbund über mechanische Verzahnung oder mittels Van-der-Waals-Kräften realisiert ist und die chemische Kopplung von Polymerkörpern und Schicht oder Schichtverbund über chemisch kovalente Bindungen.

7. Oberflächenstrukturierte Polymerkörper nach Anspruch 1, bei denen die Verformung innerhalb einer Verformungsart auf einem Polymerkörper periodisch und anisotrop ist.

8. Oberflächenstrukturierte Polymerkörper nach Anspruch 1, bei denen die Verformung bei der Anordnung von mehreren Verformungsarten auf einem Polymerkörper innerhalb einer Anordnung periodisch und isotrop ausgerichtet ist, zwischen den verschiedenen Verformungsarten anisotrop zueinander ausgerichtet ist.

9. Oberflächenstrukturierte Polymerkörper nach Anspruch 1, bei denen die Polymerkörper mehrere Verformungsarten aufweisen, die sich hinsichtlich Periodizität, Abmessungen und/oder Form der Verformungen unterscheiden.

10. Oberflächenstrukturierte Polymerkörper nach Anspruch 1, bei denen die Materialien der Polymerkörper Elastomere, thermoplastische Elastomere, Thermoplaste und/oder Duromere sind oder diese mindestens an ihrer zu beschichtenden Oberfläche vorhanden sind oder enthalten.

11. Oberflächenstrukturierte Polymerkörper nach Anspruch 1, bei denen die Schicht oder der Schichtverbund aus metallischen, polymeren, polymerverbundartigen, keramischen oder glasartigen Materialien besteht.

12. Oberflächenstrukturierte Polymerkörper nach Anspruch 1, bei denen der E-Modul des Materials des Polymerkörpers um mindestens 1 Größenordnung geringer ist als der E-Modul der Schichtmaterialien.

13. Verfahren zur Herstellung von oberflächenstrukturierten Polymerkörpern, bei dem Polymerkörper mit Abmessungen mindestens $\geq$ 100 cm$^2$ einer Dehnung in mindestens einer Richtung mindestens oberhalb der kritischen Faltenbildungsspannung und bis maximal unterhalb der Bruchspannung des Materials der Polymerkörper unterzogen werden, im Stadium der Dehnung die Oberflächen der Polymerkörper mit mindestens einer nano- bis mikrometerdicken Schicht oder Schichtverbund mittels eines atmosphärischen Plasmas oder mittels Drucken oder mittels Rakeln beschichtet werden, und nachfolgend mindestens bereichsweise die Dehnung der Polymerkörper aufgehoben wird, wobei Materialen der Polymerkörper eingesetzt werden, deren E-Modul geringer ist als der E-Modul der aufgebrachten Schichtmaterialien, und wobei der Herstellungsprozess kontinuierlich durchgeführt wird.

14. Verfahren nach Anspruch 13, bei dem die kritische Faltenbildungsspannung des Materials der Polymerkörper ermittelt wird gemäß

$$\sigma_c = \frac{F_c}{h\,w} = \left[ \frac{9}{64} \left( \frac{E_s}{1 - {v_s}^2} \right) \left( \frac{E_k}{1 - {v_k}^2} \right)^2 \right]^{1/3}$$

15. Verfahren nach Anspruch 13, bei dem die Schichtaufbringung mittels atmosphärischer Plasmen, wie mittels Plasma-Jet, mittels Corona-Entladung oder mittels dielektrischer Barriereentladung durchgeführt wird.

16. Verfahren nach Anspruch 13, bei dem Precursormaterialien der Schichtmaterialien eingesetzt werden.

17. Verfahren nach Anspruch 13, bei dem die Schichtaufbringung mittels eines Plasma-Jets realisiert wird, dessen Plasma-Wirkungsquerschnitt strahlförmig, rotierend kreisförmig und/oder linear flächig ist.

**EUROPÄISCHER RECHERCHENBERICHT**

Nummer der Anmeldung

EP 18 19 8847

**EINSCHLÄGIGE DOKUMENTE**

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2014/017454 A1 (BOYCE MARY CUNNINGHAM [US] ET AL) 16. Januar 2014 (2014-01-16) * Absätze [0005] - [0010], [0013], [0044] - [0050], [0052], [0057], [0059], [0070], [0084] - [0087], [0124] - [0126], [0131], [0139]; Ansprüche; Beispiel 10 * * Absätze [0142] - [0145], [0169], [0200] * | 1-17 | INV. C08J7/04 C08J7/12 B29C59/18 B29C61/02 B81C1/00 B08B17/06 |
| X | US 2010/116430 A1 (YANG SHU [US] ET AL) 13. Mai 2010 (2010-05-13) * Absätze [0013], [0041] - [0044]; Ansprüche; Abbildungen * | 1-17 | |
| X | US 2015/202821 A1 (SAHA SOURABH KUMAR [US] ET AL) 23. Juli 2015 (2015-07-23) * Absätze [0001], [0017] - [0022] * | 1-17 | |
| X | US 2012/212820 A1 (JIANG HANQING [US] ET AL) 23. August 2012 (2012-08-23) * Absätze [0042], [0051], [0053], [0064]; Ansprüche * | 1-17 | RECHERCHIERTE SACHGEBIETE (IPC) |
| X | KR 2017 0025464 A (PUSAN NAT UNIV INDUSTRY-UNIV COOP FOUND [KR]) 8. März 2017 (2017-03-08) * Zusammenfassung * | 1-17 | C08J B29C B08B B82B B81C |
| X | DE 199 46 252 A1 (FRAUNHOFER GES FORSCHUNG [DE]) 5. April 2001 (2001-04-05) * das ganze Dokument * | 1-17 | |

-/--

Der vorliegende Recherchenbericht wurde für alle Patentansprüche erstellt

| Recherchenort | Abschlußdatum der Recherche | Prüfer |
|---|---|---|
| München | 28. Februar 2019 | Pamies Olle, Silvia |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
................................................................
& : Mitglied der gleichen Patentfamilie, übereinstimmendes Dokument

EPO FORM 1503 03.82 (P04C03)

Europäisches
Patentamt

European
Patent Office

Office européen
des brevets

# EUROPÄISCHER RECHERCHENBERICHT

Nummer der Anmeldung

EP 18 19 8847

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 2012/031201 A2 (MASSACHUSETTS INST TECHNOLOGY [US]; EGGENSPIELER DAMIEN [US]; INCE GOZ) 8. März 2012 (2012-03-08) <br> * Seite 1, Zeilen 27-31; Ansprüche; Abbildungen; Beispiele * <br> * Seite 5, Zeile 29 - Seite 10, Zeile 31 * <br> * Seite 12, Zeilen 8-21 * <br> * Seite 16, Zeilen 1-15 * <br> ----- | 1-17 | |

RECHERCHIERTE
SACHGEBIETE (IPC)

Der vorliegende Recherchenbericht wurde für alle Patentansprüche erstellt

| Recherchenort | Abschlußdatum der Recherche | Prüfer |
|---|---|---|
| München | 28. Februar 2019 | Pamies Olle, Silvia |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
...............................................................................
& : Mitglied der gleichen Patentfamilie, übereinstimmendes
    Dokument

EPO FORM 1503 03.82 (P04C03)

Seite 2 von 2

**EP 3 470 456 A1**

**ANHANG ZUM EUROPÄISCHEN RECHERCHENBERICHT
ÜBER DIE EUROPÄISCHE PATENTANMELDUNG NR.**

EP 18 19 8847

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

28-02-2019

| Im Recherchenbericht angeführtes Patentdokument | Datum der Veröffentlichung | Mitglied(er) der Patentfamilie | Datum der Veröffentlichung |
|---|---|---|---|
| US 2014017454 A1 | 16-01-2014 | US 2014017454 A1<br>WO 2014011222 A1 | 16-01-2014<br>16-01-2014 |
| US 2010116430 A1 | 13-05-2010 | US 2010116430 A1<br>WO 2008121784 A1 | 13-05-2010<br>09-10-2008 |
| US 2015202821 A1 | 23-07-2015 | US 2015202821 A1<br>US 2017095966 A1 | 23-07-2015<br>06-04-2017 |
| US 2012212820 A1 | 23-08-2012 | KEINE | |
| KR 20170025464 A | 08-03-2017 | KEINE | |
| DE 19946252 A1 | 05-04-2001 | DE 19946252 A1<br>EP 1216426 A1<br>WO 0123916 A1 | 05-04-2001<br>26-06-2002<br>05-04-2001 |
| WO 2012031201 A2 | 08-03-2012 | US 2012058302 A1<br>WO 2012031201 A2 | 08-03-2012<br>08-03-2012 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102012010635 A1

- WO 2012031201 A3

**In der Beschreibung aufgeführte Nicht-Patentliteratur**

- **N. BOWDEN et al.** *Nature,* 1998, vol. 393 (6681), 146-9

- **Y. XIA et al.** *Science,* 1998, vol. 37 (5), 550-575